# EUROPEAN PATENT APPLICATION

(11) **EP 3 893 318 A1**
(43) Date of publication of application: **13.10.2021**
(21) Application number: 20866918.4
(22) Date of filing: 28.02.2020
(51) Int. Cl.: H01M 10/42, H02J 7/00

(54) **BATTERY PACK MANAGEMENT SYSTEM, BATTERY PACK, VEHICLE AND MANAGEMENT METHOD**

(71) Applicant: Dongguan Amperex Technology Limited, Dongguan, Guangdong 523808 (CN)
(72) Inventor: LIU, Xing, Dongguan City, Guangdong 523808 (CN); HE, Sheng, Dongguan City, Guangdong 523808 (CN)
(74) Representative: Klunker IP Patentanwälte PartG mbB
(86) International application number: PCT/CN2020/077081
(87) International publication number: WO 2021/168769

(57) **Abstract**

This application relates to a battery pack management system, a battery pack, a vehicle, and a management method. A method for dynamically managing parallel connection of a plurality of battery packs is provided, applied to a first battery pack, where the method includes: monitoring, by a BMS, states of the first battery pack and other battery packs, the states of the first battery pack and the other battery packs including a disconnected state and a connected state; and when determining that a difference between a power level of the first battery pack and a power level of another power pack in the connected state is in a preset threshold range, controlling, by the BMS based on the determination, the first battery pack to switch from the disconnected state to the connected state, the first battery pack being connected in parallel with the another battery pack; where the connected state includes a charge state and a discharge state, and the first battery pack is charged in the charge state and discharged in the discharge state.

## Description

### TECHNICAL FIELD

This application relates to the field of battery technologies, and in particular, to a battery pack management system, a battery pack, a vehicle, and a management method.

### BACKGROUND

Currently, for battery powered vehicles, it is required to efficiently manage the charge and discharge of a plurality of battery packs in the vehicle to improve vehicle mileage and battery efficiency. When a vehicle is moving, a single battery pack can be used for operation, or a plurality of battery packs connected together in parallel can be used for operation. After a long time use in charging and discharging, battery packs with a same initial state may gradually show inconsistent power levels, so that the plurality of battery packs are unable to continue to be charged and discharged simultaneously.

For example, in a general vehicle design, a same port is used as a charging port and a discharging port, that is, a same port mode is used. When a plurality of battery packs with significantly different power levels are charged in parallel, a risk of circulating current charging (that is, a battery pack with a high power level charges a battery pack with a low power level) may arise. In addition to decreasing charge efficiency, the circulating current charging may also cause irreversible damage to battery cells.

For example, a vehicle is equipped with a plurality of battery packs. However, in a process of using the battery packs one by one, when the power required to be supplied by a single battery pack to the load is unchanged or increased, it may cause a large output burden on the single battery pack, which not only limits power output of the plurality of battery packs, but also might lead to a relatively low power utilization of the plurality of battery packs.

In addition, when the plurality of battery packs are used simultaneously, an additional host control module is needed, which increases the cost.

### SUMMARY

According to some embodiments of this application, this application provides a method for dynamically managing parallel connection of a plurality of battery packs, which is applied to a first battery pack. The method includes: monitoring states of a first battery pack and other battery packs, the states of the first battery pack and the other battery packs including a disconnected state and a connected state; and when a BMS (Battery Management System, battery management system) determines that a difference between a power level of the first battery pack and a power level of another power pack in the connected state is in a preset threshold range, controlling, by the BMS based on the determination, the first battery pack to switch from the disconnected state to the connected state; where the connected state includes a charge state and a discharge state, and the first battery pack is charged in the charge state and discharged in the discharge state.

According to some embodiments of this application, when detecting a discharge signal and detecting that the other battery packs are in the disconnected state and that the first battery pack has a highest power level among the plurality of battery packs, the BMS controls the first battery pack to switch from the disconnected state to the discharge state.

According to some embodiments of this application, when a charge signal is detected and it is detected that the other battery packs are in the disconnected state and that the first battery pack has a lowest power level among the plurality of battery packs, the first battery pack is controlled to switch from the disconnected state to the charge state.

According to some embodiments of this application, a step of the first battery pack switching from the discharge state to the charge state includes: switching from the discharge state to the disconnected state, and then from the disconnected state to the charge state.

According to some embodiments of this application, a step of the first battery pack switching from the charge state to the discharge state includes: switching from the charge state to the disconnected state, and then from the disconnected state to the discharge state.

According to some embodiments of this application, when it is detected that the first battery pack is in the connected state and fails, the first battery pack is controlled to switch from the connected state to the disconnected state.

According to some embodiments of this application, this application provides a management system including a plurality of battery packs, the plurality of battery packs including a first battery pack and other battery packs, where the first battery pack includes battery cells and a BMS, and the management system includes: a communications cable, where the first battery pack and the other battery packs are connected to the communications cable; the BMS including a charge control module, a discharge control module, and a pre-discharge control module; and a main control module, configured to: monitor the first battery pack and report a state of the first battery pack to the communications cable, and obtain states of the other battery packs from the communications cable, the states of the first battery pack and the other battery packs including a disconnected state and a connected state; where when the BMS determines that a difference between a power level of the first battery pack and a power level of another power packs in the connected state is in a preset threshold range, the BMS controls, based on the determination, the charge control module, the discharge control module, and the pre-discharge control module to parallel the first battery pack to the other battery packs to switch the first battery pack from the disconnected state to the connected state; where the connected state includes a charge state and a discharge state, and the first battery pack and the other battery packs are charged in the charge state and discharged in the discharge state.

According to some embodiments of this application, the charge control module and the discharge control module are connected in series.

According to some embodiments of this application, the pre-discharge control module is connected in parallel with the charge control module and the discharge control module which are connected in series.

According to some embodiments of this application, the first battery pack switches from the disconnected state to the connected state when both the charge control module and the discharge control module are closed.

According to some embodiments of this application, the control module is further configured to: when detecting a charge signal and detecting that the other battery packs are in the disconnected state and that the first battery pack has a lowest power level among the plurality of battery packs, control the charge control module and the discharge control module to close to switch the first battery pack from the disconnected state to the charge state.

According to some embodiments of this application, the control module is further configured to: when detecting a discharge signal and detecting that the other battery packs are in the disconnected state and that the first battery pack has a highest power level among the plurality of battery packs, control the charge control module and the discharge control module to close to switch the first battery pack from the disconnected state to the discharge state.

According to some embodiments of this application, the control module is further configured to: when controlling the discharge control module, the charge control module, and the pre-discharge control module to switch the first battery pack between the charge state and the discharge state, control all of the discharge control module, the charge control module, and the pre-discharge control module to disconnect and then close.

According to some embodiments of this application, the control module is further configured to: when detecting that a change in load current exceeds a preset value, control the discharge control module to close.

According to some embodiments of this application, the discharge control module, the charge control module, and the pre-discharge control module are switch modules, and a freewheel diode is provided in the switch modules.

According to some embodiments of this application, a battery pack includes the foregoing battery pack management system.

According to some embodiments of this application, a vehicle includes the foregoing battery pack system.

According to some embodiments of this application, the vehicle further includes a plurality of battery compartments, the plurality of battery packs being arranged in the battery compartments.

According to some embodiments of this application, a method for dynamically managing parallel connection of a plurality of battery packs is applied to the plurality of battery packs, where the method includes: monitoring states of a first battery pack and other battery packs, the states of the first battery pack and the other battery packs including a disconnected state and a connected state; and when the plurality of battery packs are all in the disconnected state, and a difference between a power level of the first battery pack and a power level of another power pack is in a preset threshold range, controlling the first battery pack to switch from the disconnected state to the connected state; and controlling the first battery pack to switch between the connected state and the disconnected state independent of the other battery packs; where the connected state includes a charge state and a discharge state, and the first battery pack and the other battery packs are charged in the charge state and discharged in the discharge state.

### BRIEF DESCRIPTION OF DRAWINGS

Drawings necessary for describing the embodiments of this application or the prior art are briefly described below, to help describe the embodiments of this application. It is obvious that the drawings described below are only some of the embodiments of this application. Those skilled in the art may still obtain drawings of other embodiments based on the structures illustrated in these drawings without creative work.
FIG. 1 is a schematic structural diagram of partial electrical connections of a vehicle including a battery pack system according to some embodiments of this application.
FIG. 2 is a schematic structural diagram of electrical connections between a battery pack and a vehicle load according to some embodiments of this application.
FIG. 3 is a flowchart of a main control method by a BMS according to some embodiments of this application.
FIG. 4 is a flowchart of a method for performing standby processing by a BMS according to some embodiments of this application.
FIG. 5 is a flowchart of a method for performing a standby operation by a BMS according to some embodiments of this application.
FIG. 6 is a flowchart of a method for performing discharge processing by a BMS according to some embodiments of this application.
FIG. 7 is a flowchart of a method for entering a discharge start-up state by a BMS according to some embodiments of this application.
FIG. 8 is a flowchart of a method for entering a discharge operating state by a BMS according to some embodiments of this application.
FIG. 9 is a flowchart of a method for entering a discharge completion state by a BMS according to some embodiments of this application.
FIG. 10 is a flowchart of a charge processing method by a BMS according to some embodiments of this application.
FIG. 11 is a flowchart of a method for entering a charge start-up state by a BMS according to some embodiments of this application.
FIG. 12 is a flowchart of a method for entering a charge operating state by a BMS according to some embodiments of this application.
FIG. 13 is a flowchart of a method for entering a charge completion state by a BMS according to some embodiments of this application.
FIG. 14 is a flowchart of a method for performing a discharge operation by a BMS according to some embodiments of this application.
FIG. 15 is a flowchart of a method for performing discharge start-up by a BMS according to some embodiments of this application.
FIG. 16 is a flowchart of a method for performing a charge operation by a BMS according to some embodiments of this application.

### DESCRIPTION OF EMBODIMENTS

Embodiments of this application are described in detail below. In the full text of the specification of this application, the same or similar components and components with the same or similar functions are indicated by similar reference signs. The embodiments related to the accompanying drawings described herein are illustrative and diagrammatic, and are used to provide a basic understanding of this application. The embodiments of this application shall not be construed as a limitation on this application.

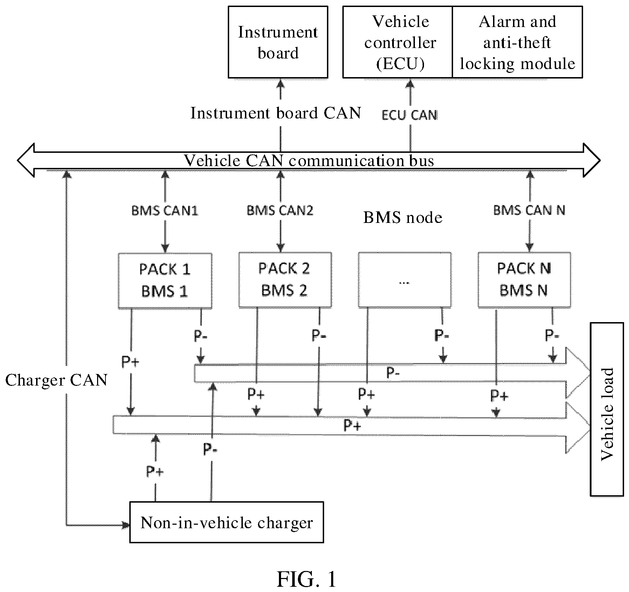

FIG. 1 is a schematic structural diagram of partial electrical connections of a vehicle including a battery pack system according to an embodiment of this application. The battery pack system includes a plurality of battery packs, which are PACK 1, PACK 2, ..., and PACK N, where N is a natural number greater than 1. Each battery pack includes a BMS and battery cells. As described in FIG. 1, PACK 1 includes BMS 1, PACK 2 includes BMS 2, and PACK N includes BMS N. In some embodiments, the vehicle includes a vehicle CAN (Controller Area Network, controller area network) communication bus. A plurality of nodes for connecting BMSs are provided in the vehicle CAN communication bus. As a BMS node, a BMS of each of the battery packs can monitor or obtain states of other battery packs from the vehicle CAN communication bus.

It should be noted that the manner in which the BMS of each of the battery packs obtains states of other battery packs is not limited to the foregoing vehicle CAN communication bus, and other wired or wireless manners may also be used, for example, through 4G (The 4th Generation Mobile Communication Technology), 5G (The 5th Generation Mobile Communication Technology), or Wi-Fi communication.

In some embodiments of this application, the plurality of battery packs supply power to or power the vehicle through a power bus with P+ and P-, where P+ is the positive electrode of the power bus, and P- is the negative electrode of the power bus. The vehicle load includes an instrument board, a motor, a vehicle controller, and the like. The instrument board, the vehicle controller ECU may alternatively be connected to the vehicle CAN communication bus through a corresponding CAN bus. In some embodiments of this application, the vehicle or the battery pack system can be connected to an external non-in-vehicle charger through the power bus, so as to charge the battery packs through the non-in-vehicle charger and the power bus. In some embodiments of this application, the vehicle further includes a plurality of battery compartments, the plurality of battery packs being arranged in the plurality of the battery compartments. After being arranged in the battery compartments, the battery packs can be configured to communicate with the vehicle CAN communication bus to monitor the states of the battery packs.

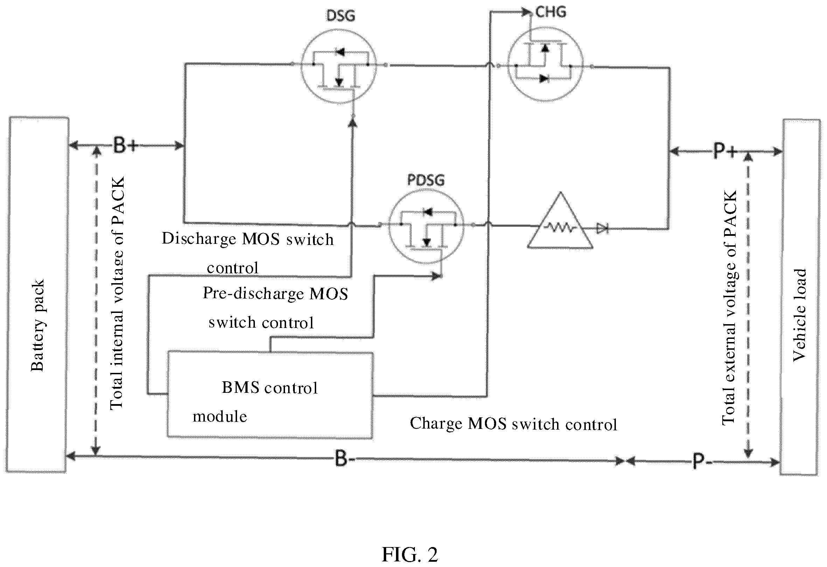

FIG. 2 is a schematic structural diagram of electrical connections between a battery pack and a vehicle load according to some embodiments of this application. The battery pack includes battery cells and a BMS, which are electrically connected. The BMS includes a charge control module, a discharge control module, a pre-discharge control module, and a BMS control module (that is, a main control module). The BMS (for example, BMS 1) connects battery cells in a first battery pack (for example, PACK 1) to a power bus or disconnects the battery cells from the power bus by controlling the charge control module, the discharge control module, and the pre-discharge control module. Connecting to a power bus includes supplying power to a vehicle load through the power bus, or being charged by a non-in-vehicle charger.

In some embodiments of this application, the charge control module and the discharge control module are connected in series. In some embodiments of this application, the pre-discharge control module is connected in parallel with the charge control module and the discharge control module which are connected in series. In some embodiments of this application, the discharge control module, the charge module, and the pre-discharge control module may be MOS (Metal-Oxide-Semiconductor Field-Effect Transistor, metal-oxide-semiconductor field-effect transistor) switch devices or relay device modules, and a freewheel diode is provided in the switch modules. The freewheel diode may still attain short-time current conduction effect when the switch device is in an open or disconnected state. In the description below, the pre-discharge switch is represented by PDSG, the discharge switch is represented by DSG, and the charge switch is represented by CHG. A common port mode in this application means that when a battery pack is in the discharge state or charge state, the discharge control module and the charge control module need to be closed at the same time.

Back to FIG. 1, in some embodiments of this application, a BMS of any one of the plurality of battery packs, PACK 1, PACK 2, ..., and PACK N refers to any one of BMS 1, BMS 2, ..., and BMS N. A BMS (for example, BMS 1) is configured to: monitor states of PACK 1 and other battery packs (one or more of PACK 2 to PACK N). The states of PACK 1 and the other battery packs include a disconnected state and a connected state. A battery pack in the disconnected state means that battery cells in the battery pack are disconnected from the power bus. In other words, a battery pack disconnected from the power bus cannot be discharged or charged. A battery pack in the connected state means that battery cells in the battery pack are connected to the power bus, and can transmit power to the vehicle load or be charged by a non-in-vehicle charger through the power bus. States of the battery packs correspond to system states of the vehicle. In some embodiments of this application, the system states of the vehicle include a standby state, a charge state, and a discharge state. In the standby state, a protection signal is present, with absence of any PACK_ID signal, vehicle start-up ACC, ON signal, communication signal, or charger-in CHG_IN signal, or the battery pack being in the disconnected state. In the standby state, both the charge switch and the discharge switch are open. In the charge state, a charge signal is present, and charging is allowed. In the discharge state, a discharge signal is present, and discharging is allowed.

In some embodiments of this application, the system states of the vehicle further include an anti-theft locking state which refers to use of a key to set vehicle locking after the vehicle is shut down, such that an alarm is launched while a motor controller locks wheels, upon detection of vehicle vibration or wheel rotation. During locking, no communication exists between the instrument board and the battery system. The battery pack needs to be awakened without communication according to output requirements of an alarm device and a lock control module, with a main circuit closed in time to provide locking current.

In some embodiments of this application, when in the discharge state, battery cells in the battery PACK 1 are connected to the power bus to output power through the power bus when BMS 1 detects that PACK 1 and other battery packs PACK 2 to PACK N are in the disconnected state and that the battery cells in the battery pack PACK 1 have a highest power level. In a discharging process of PACK 1, BMS 2 to BMS N continuously monitor power levels of their respective battery packs and the power level of PACK 1. When detecting that the power level of PACK 2 is in a preset threshold range related to the current power level of the discharging PACK 1, BMS 2 controls PACK 2 to connect to the power bus to discharge in parallel with PACK 1. Because power levels of PACK 1, PACK 2, and PACK N may be the same or different, when power is provided to the vehicle or when the vehicle is in a driving state, if the BMS in any one of the battery packs detects that its respective power level is in a preset threshold range related to the power level of a currently discharging battery pack, the any one battery pack may be paralleled to the currently discharging battery pack to collectively provide power through the power bus. For example, when determining that a difference between the power level of battery cells in PACK 1 and power levels of other currently discharging battery packs PACK 2 to PACK N is in a preset threshold range, BMS 1 in PACK 1 controls PACK 1 to switch from the disconnected state to the connected state, where PACK 1 is connected in parallel with the other battery packs. In other words, PACK 1 is controlled to be paralleled with the currently discharging battery packs to collectively provide power through the power bus. The foregoing preset threshold range is determined by the power levels of the currently discharging battery packs. Other battery packs with lower power levels may be successively paralleled to the currently discharging battery packs according to the foregoing method, to collectively provide output through the power bus.

In some embodiments of this application, without limitation to the above description, when in the discharge state, the battery pack with the highest power level may alternatively be any one or more of PACK 2 to PACK N. When a plurality of battery packs have the highest power level, since it is impossible that power levels of the battery packs be exactly the same, the power levels of the plurality of battery packs being in a preset power level range means that the plurality of battery packs have substantially the same power level and can be connected to the power bus in parallel altogether as the battery packs with the highest power level to provide power output at the same time. For example, when an actual power level of a battery pack is E1, battery packs with power levels in a preset threshold range E1-E2 to E1+E3 are considered to have substantially the same power level as the battery pack with the power level of E1. E1, E2, and E3 may be a percentage of the power level of the whole battery pack, and E2 and E3 may be the same or different. For example, E1 is 95%, E2 is 0.8%, and E3 is 0.8% or 1%. A battery pack with a power level not within the preset threshold range E1-E2 to E1+E3 does not have the same power level.

In some embodiments of this application, when PACK 1 is discharged to a preset power level range EQ2, the discharge of PACK 1 is suspended. In other words, PACK 1 is switched to the disconnected state. Then, one or more of PACK 2 to PACK N with the same power level as that of PACK 1 before the discharge are discharged to EQ1, and at this point, PACK 1, at its own discretion, can be paralleled to the one or more of PACK 2 to PACK N to further discharge at the same time.

In some embodiments of this application, when in the charge state, battery cells in the battery PACK 1 are connected to the power bus and charged through the power bus when BMS 1 detects that the first battery pack (for example, PACK 1) and other battery packs (for example, one or more of PACK 2 to PACK N) are in the disconnected state and that the battery cells in the battery PACK 1 has a lowest power level. In a charging process of PACK 1, BMS 2 to BMS N continuously monitor power levels of their respective battery packs and the power level of PACK 1. When detecting that the power level of PACK 2 is in a preset threshold range related to the current power level of the charging PACK 1, BMS 2 controls PACK 2 to connect to the power bus to charge in parallel with PACK 1. Since power levels of PACK 1, PACK 2, and PACK N may be the same or different, during charging, if the BMS in any one of the battery packs detects that its respective power level is in a preset threshold range related to a power level of a currently charging battery pack, the any one battery pack may be paralleled to the currently charging battery pack to be charged through the power bus at the same time. For example, when determining that a difference between the power level of battery cells in PACK 1 and the power levels of other currently charging battery packs, PACK 2 to PACK N is in a preset threshold range, BMS 1 in PACK 1 controls PACK 1 to switch from the disconnected state to the connected state, where PACK 1 is connected in parallel with the other battery packs. In other words, PACK 1 is controlled to be paralleled with the currently charging battery packs to be charged collectively through the power bus. The foregoing preset threshold range is determined by the power levels of the currently charging battery packs. Other battery packs with higher power levels may be successively paralleled to the currently charging battery packs according to the foregoing method, to be charged collectively through the power bus.

In some embodiments of this application, without limitation to the above description, the battery pack with the lowest power level may alternatively be any one or more of PACK 2 to PACK N. When a plurality of battery packs have the lowest power level, because it is impossible that the power levels of the battery packs be exactly the same, the power levels of the plurality of battery packs being in a preset power level range means that the plurality of battery packs have substantially the same power level and can be connected to the power bus in parallel altogether as the battery packs with the lowest power level to be charged at the same time.

In some embodiments of this application, when a battery pack switches from the discharge state to the charge state, the pre-discharge switch is closed first, then the charge switch is closed, and finally the discharge switch is closed. In some embodiments of this application, when a battery pack switches from the charge state to the discharge state, the pre-discharge switch is closed first, then the discharge switch is closed, and finally the charge switch is closed. It should be noted that depending on the quantity and types of switches provided, the sequence of closing for switching between the charge state and the discharge state is not limited to the description above, and may be selected according to the specific situation.

It should be noted that any one of the battery packs in PACK 1 to PACK N may switch between the charge state, discharge state, and standby state (that is, the disconnected state) independent of other battery packs based on its own state and states of the other battery packs, thereby implementing dynamic management on parallel connection of the battery packs without any additional host control module set up. This can meet the demands for large power output and capacity expansion of the vehicle load in real time, with strong versatility and low costs.

In some embodiments of this application, when detecting failure of the first battery pack, the BMS in the first battery pack controls the first battery pack to switch from the charge state or discharge state to the disconnected state. In addition, when the BMSs in other battery packs detect that a battery pack in the connected state fails and switches to the disconnected state, one of the other battery packs accordingly chooses to connect to the power bus to continue to provide output. For example, a battery pack having a second highest power level in the other battery packs may actively choose to connect to the power bus to provide output.

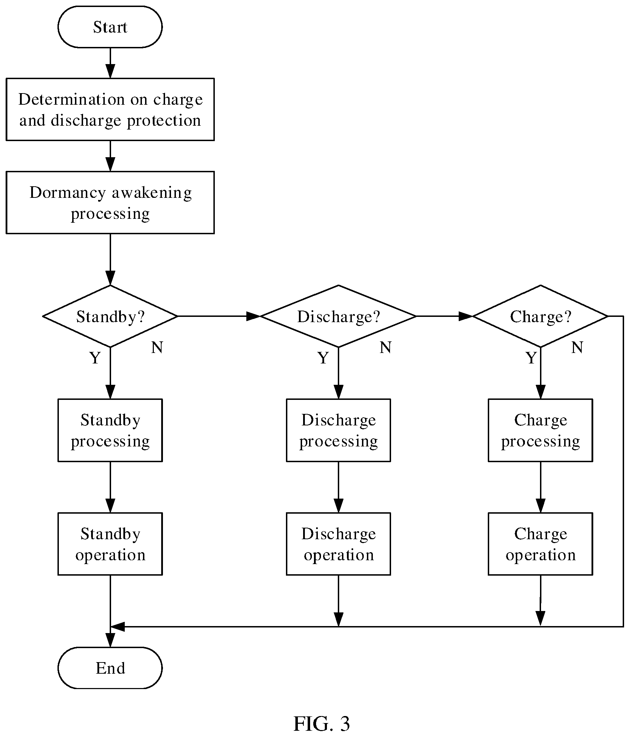

Flowcharts of the method for managing parallel connection of a plurality of battery packs according to some embodiments of this application are shown in FIGs. 3 to 16, which illustrate a control and management method for each battery pack by a BMS. The BMS may be BMS 1, or BMS 2, or BMS N. In other words, the foregoing method may be executed by any one of BMS 1 to BMS N.

FIG. 3 is a flowchart of a main control method by a BMS according to some embodiments of this application. In FIG. 3, a BMS in any one of the battery packs (for example, BMS 1 in PACK 1) makes a determination on charge and discharge protection. After a charge and discharge protection operation is performed, dormancy awakening processing is performed. The performing dormancy awakening processing includes: the BMS control module controls the PDSG (that is, the pre-discharge switch) to close, and initializes related parameters to determine whether the battery pack has entered a standby state. If determining that the battery pack has entered the standby state ("Y" for "Yes", and "N" for "No" in the figure), the BMS performs standby processing and a standby operation; and if determining that the battery pack has not entered the standby state, the BMS further determines whether the battery pack has entered a discharge state. If the battery pack has entered the discharge state, the BMS performs discharge processing and a discharge operation; or if the battery pack has not entered the discharge state, the BMS further determines whether the battery pack has entered a charge state. If determining that the battery pack has entered the charge state, the BMS performs charge processing and a charge operation. If determining that the battery pack has not entered the charge state, the BMS ends the processing.

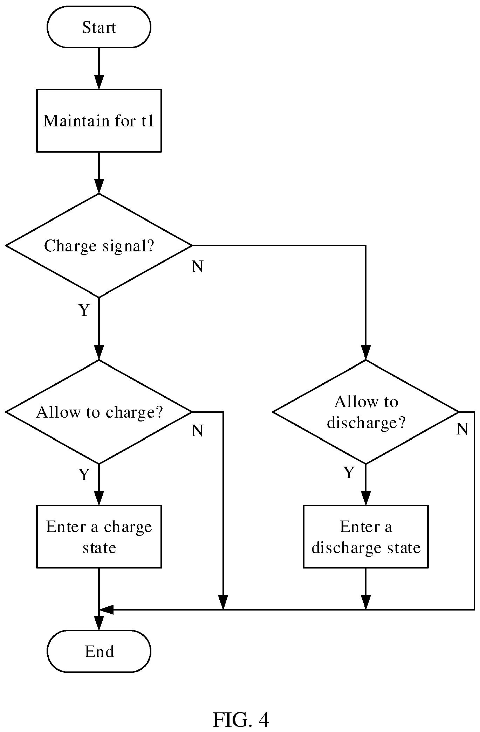

FIG. 4 is a flowchart of a method for performing standby processing by a BMS (for example, BMS 1) according to some embodiments of this application. In FIG. 4, after a battery pack enters the standby state, the BMS control module maintains this for a time of t1 and then determines whether a charge signal is detected. Herein, t1 may be 0.6s. If a charge signal is detected or received, the BMS further determines whether any allow-to-charge signal or allow-to-charge operation instruction is detected or received. If an allow-to-charge signal or allow-to-charge operation instruction is detected or received, the battery pack enters a charge state. If no allow-to-charge signal or allow-to-charge operation instruction is detected or received, the processing is ended. If no charge signal is detected or received, the BMS further determines whether any allow-to-discharge signal or allow-to-discharge operation instruction is detected or received. If yes, the battery pack enters a discharge state; or if no, the processing is ended.

In some embodiments of this application, when detecting a charge signal, and detecting that other battery packs are in the disconnected state and that PACK 1 has a highest power level among a plurality of battery packs, the BMS (for example, BMS 1) controls the discharge switch (or DSG) and the charge switch (CHG) to close to switch PACK 1 from the disconnected state to the discharge state. In some embodiments of this application, when detecting that one or more battery packs in the other battery packs are in the discharge state and that the power level of PACK 1 meets a preset threshold range, BMS 1 controls the charge switch (or CHG) and the discharge switch (DSG) to close to switch PACK 1 from the disconnected state to the discharge state.

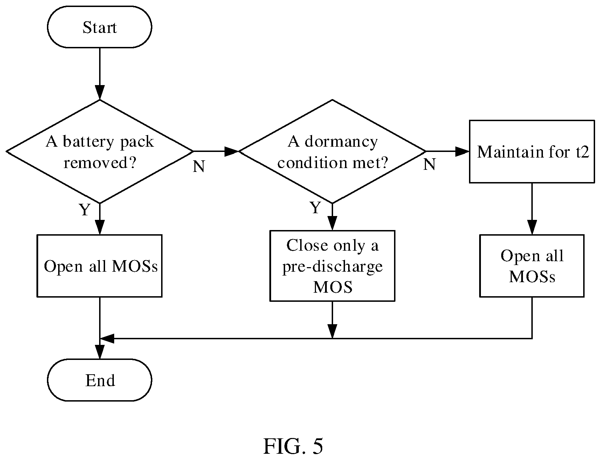

FIG. 5 is a flowchart of a method for performing a standby operation by a BMS (for example, BMS 1) according to some embodiments of this application. In FIG. 5, after a standby processing step is completed, the BMS control module determines whether PACK 1 is removed or disconnected from the power bus. If yes, the BMS opens all switches including the discharge switch, the charge switch, and the pre-discharge switch; or if no, the BMS further determines whether a dormancy condition is met. If the dormancy condition is met, the BMS closes only the pre-discharge switch; and if the dormancy condition is not met, the BMS opens all switches after a time of t2.

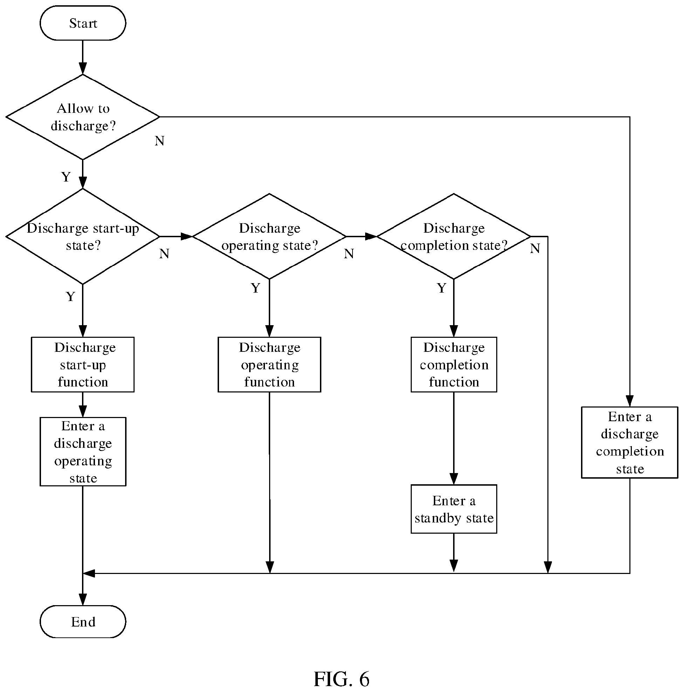

FIG. 6 is a flowchart of a method for performing discharge processing by a BMS according to some embodiments of this application. In FIG. 6, the BMS (for example, BMS 1) determines whether any allow-to-discharge signal or allow-to-discharge operation instruction is detected or received. If yes, the BMS determines whether it is in a discharge start-up state; or if no, the BMS enters a discharge completion state. If determining that the BMS is in the discharge start-up state, the BMS enters a discharge operating state after executing a discharge start-up function. If determining that the BMS is not in the discharge start-up state, the BMS further determines whether it is in the discharge operating state. If determining that the BMS is in the discharge operating state, the BMS executes a discharge operating function; or if determining that the BMS is not in the discharge operating state, the BMS further determines whether it is in the discharge completion state. If determining that the BMS is in the discharge completion state, the BMS enters a standby state after executing a discharge completion function; or if determining that the BMS is not in the discharge completion state, the BMS ends the discharge processing step. The discharge start-up state refers to a state corresponding to a process in which the DSG or discharge switch changes from open to closed. The discharge operating state refers to a state in which the DSG or discharge MOS switch is closed or large current discharge is allowed. The discharge completion state refers to a state corresponding to a process in which the DSG or discharge switch changes from closed to open.

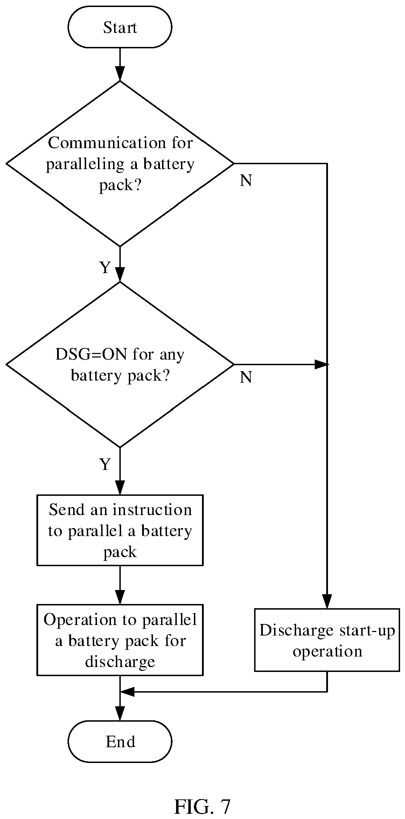

FIG. 7 is a flowchart of a method for entering a discharge start-up state by a BMS according to some embodiments of this application. In FIG. 7, the BMS (for example, BMS 1) monitors whether there is communication for paralleling a battery pack after entering the discharge start-up state. If yes, the BMS further determines whether a discharge switch or DSG of any other battery pack is detected to be in a closed state (that is, DSG=ON); or if no, performs a discharge start-up operation. If detecting that a discharge switch of another battery pack is in the closed state or DSG=ON, the BMS performs an operation to parallel a battery pack for discharge after sending an instruction to parallel a battery pack; or if detecting that a discharge switch of no other battery pack is in the closed state or DSG=ON, the BMS performs a discharge start-up operation.

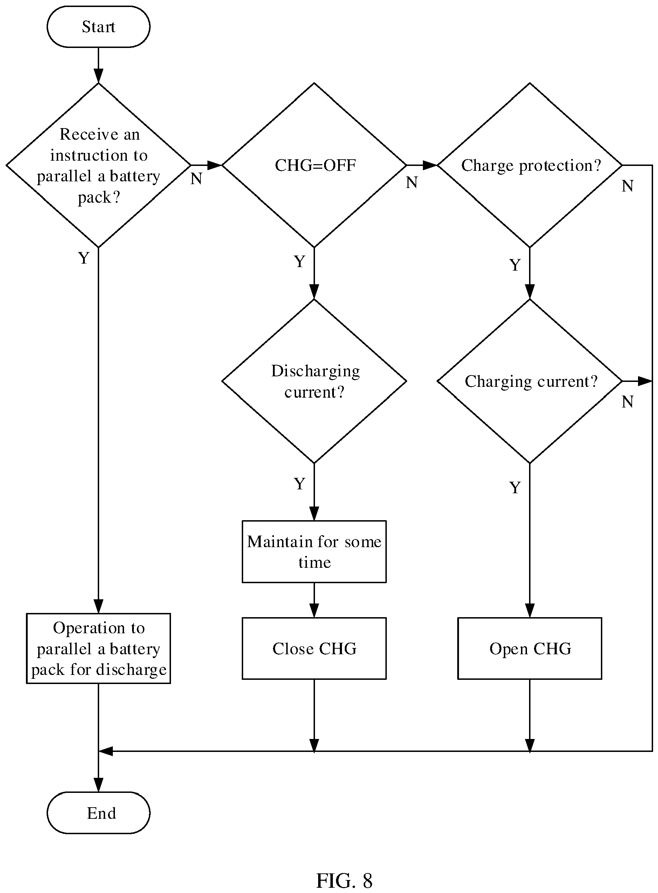

FIG. 8 is a flowchart of a method for entering a discharge operating state by a BMS according to some embodiments of this application. In FIG. 8, the BMS (for example, BMS 1) determines whether an instruction to parallel a battery pack is received after entering the discharge operating state. If yes, the BMS performs an operation to parallel a battery pack for discharge; or if no, further determines whether a charge switch or CHG is open. If the charge switch or CHG is open (CHG=OFF), the BMS further determines whether discharging current is detected. If yes, the BMS maintains the state for some time and then closes the CHG; or if the CHG is closed or CHG=ON, the BMS further determines whether there is charging protection. If no, the BMS ends the processing; or if yes, further determines whether there is charging current. If there is charging current, the BMS opens the CHG; or if there is no charging current, ends the discharge operating state.

It should be noted that under the discharge operating state, the instruction to parallel a battery pack is an instruction detected to parallel another battery pack. With the CHG open, when whether to perform an operation to close the CHG is determined based on the presence of discharging current, the determination can be made based on a PACK voltage. In some embodiments, when there is discharging current, a PACK voltage is 0.7 V lower than a battery voltage, but not limited thereto.

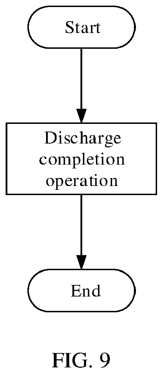

FIG. 9 is a flowchart of a method for entering a discharge completion state by a BMS according to some embodiments of this application. As shown in FIG. 9, the BMS (for example, BMS 1) performs a discharge completion operation when in a discharge completion state, and exits from the discharge state after the discharge completion operation is performed.

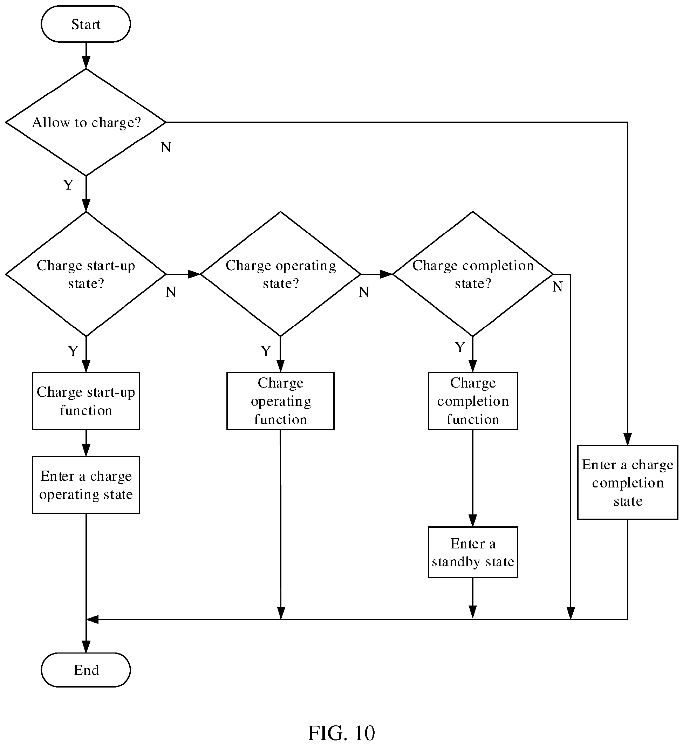

FIG. 10 is a flowchart of a method for charge processing by a BMS according to some embodiments of this application. In FIG. 10, the BMS (for example, BMS 1) determines whether any allow-to-charge signal or allow-to-charge operation instruction is detected or received. If yes, the BMS determines whether it is in a charge start-up state; or if no, enters a charge completion state. If determining that the BMS is in the charge start-up state, the BMS (for example, BMS 1) enters a charge operating state after executing a charge start-up function. If determining that the BMS is not in the charge start-up state, the BMS further determines whether it is in the charge operating state. If determining that the BMS is in the charge operating state, the BMS executes a charge operating function; or if determining that the BMS is not in the charge operating state, the BMS further determines whether it is in the charge completion state. If determining that the BMS is in the charge completion state, the BMS enters a standby state after executing a charge completion function; or if determining that the BMS is not in the charge completion state, the BMS ends the charge processing step. The charge start-up state refers to a state corresponding to a process in which the CHG or charge switch changes from open to closed. The charge operating state refers to a state in which the CHG or charge switch is closed or charge is allowed. The charge completion state refers to a state corresponding to a process in which the CHG or charge switch changes from closed to open.

In some embodiments of this application, when detecting a charge signal, and detecting that the other battery packs are in the disconnected state and that PACK 1 has a lowest power level among the plurality of battery packs, the BMS (for example, BMS 1) controls the charge switch (or CHG) and the discharge switch (DSG) to close to switch PACK 1 from the disconnected state to the charge state. In some embodiments of this application, when detecting that one or more battery packs in the other battery packs are in the charge state and that the power level of PACK 1 meets a preset threshold range, BMS 1 controls the charge switch (or CHG) and the discharge switch (DSG) to close to switch PACK 1 from the disconnected state to the charge state.

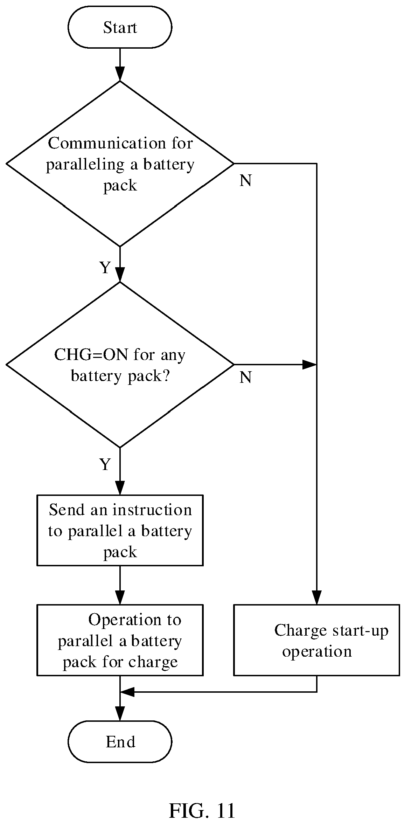

FIG. 11 is a flowchart of a method for entering a charge start-up state by a BMS (for example, BMS 2) according to some embodiments of this application. In FIG. 11, BMS 1 monitors whether there is communication for paralleling a battery pack after entering the charge start-up state. If yes, the BMS further determines whether a charge switch or CHG of any other battery pack is detected to be in a closed state (that is, CHG=ON); or if no, performs a charge start-up operation. If detecting that a charge switch of another battery pack is in the closed state or CHG=ON, the BMS performs an operation to parallel a battery pack for charge after sending an instruction to parallel a battery pack; or if detecting that a charge switch of no other battery pack is in the closed state or CHG=ON, the BMS performs a charge start-up operation.

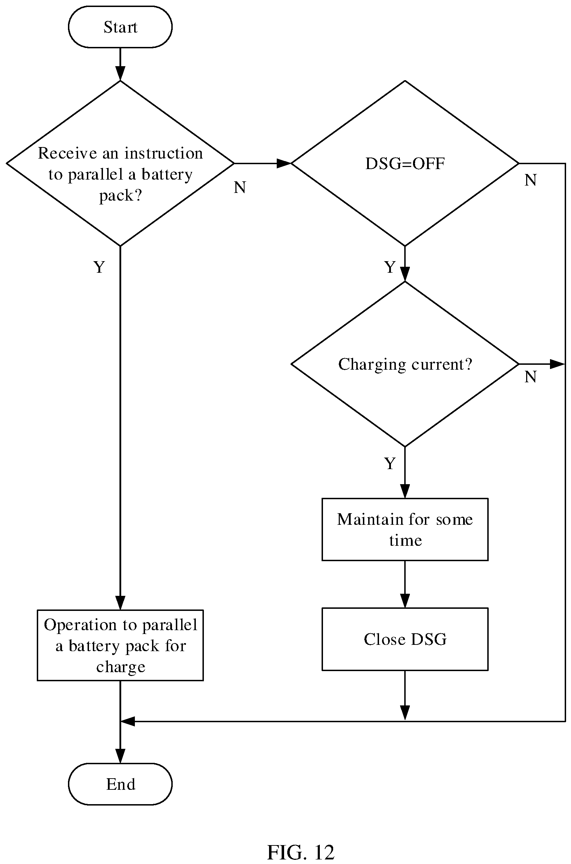

FIG. 12 is a flowchart of a method for entering a charge operating state by a BMS (for example, BMS 1) according to some embodiments of this application. In FIG. 12, the BMS determines whether an instruction to parallel a battery pack is received after entering the charge operating state. If yes, the BMS performs an operation to parallel a battery pack for charge; or if no, the BMS further determines whether a discharge switch or DSG is open (that is, DSG=OFF). If the discharge switch is open or DSG=OFF, the BMS further determines whether charging current is detected. If charging current is detected, the BMS maintains the state for some time and then closes the DSG; or if no charging current is detected, the BMS ends the charge operating state. If the discharge switch is closed or DSG=ON, the BMS ends the charge operating state.

It should be noted that under the charge operating state, the instruction to parallel a battery pack is an instruction detected to parallel another battery pack. With the DSG open, when whether to perform an operation to close the DSG is determined based on the presence of charging current, the determination can be made based on a PACK voltage. In some embodiments, when there is charging current, a PACK voltage is 0.7 V lower than a battery voltage, but not limited thereto.

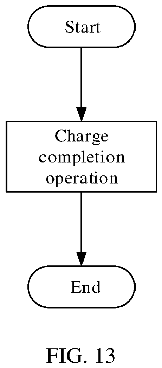

FIG. 13 is a flowchart of a method for entering a charge completion state by a BMS (for example, BMS 1) according to some embodiments of this application. As shown in FIG. 13, the BMS performs a charge completion operation when in a charge completion state, and exits from the charge state after the charge completion operation is performed.

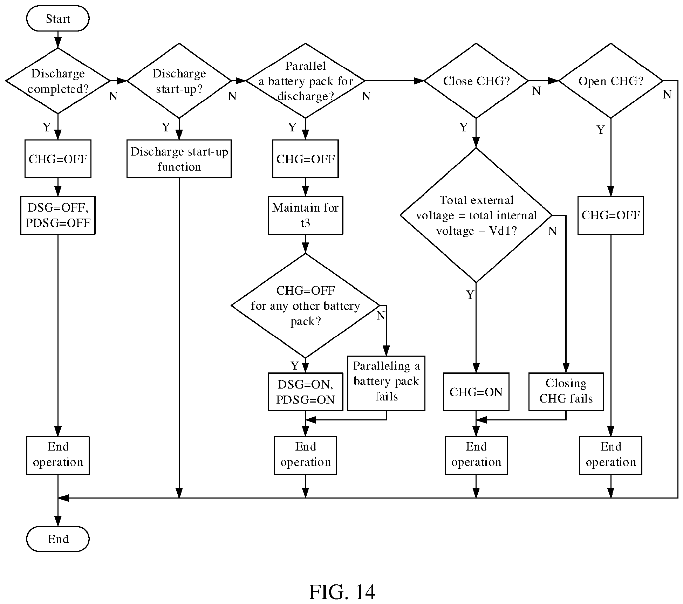

FIG. 14 is a flowchart of a method for performing a discharge operation by a BMS (for example, BMS 1) according to some embodiments of this application. In FIG. 14, the BMS determines whether discharging is completed after performing discharge processing. If yes, the BMS opens the charge switch to make CHG=OFF, and then opens the discharge switch and the pre-discharge switch to make DSG=OFF and PDSG=OFF to end the discharge operation; or if no, the BMS determines whether to perform a discharge start-up operation. If a discharge start-up operation is to be performed, the BMS executes a discharge start-up function; or if no discharge start-up operation is to be performed, the BMS further determines whether to perform an operation to parallel a battery pack for discharge. If an operation to parallel a battery pack for discharge is to be performed, the BMS opens the charge switch to make CHG=OFF, maintains the state for a time of t3, and then further determines whether charge switches of other battery packs are open. If yes, the BMS closes the discharge module and the pre-discharge module to make DSG=ON and PDSG=ON to end the operation to parallel a battery pack for discharge; or if no, paralleling a battery pack fails, and the BMS ends the operation to parallel a battery pack for discharge. Herein, t3 is Is, but not limited thereto. If no operation to parallel a battery pack for discharge is to be performed, the BMS further determines whether to close the charge switch (that is to make CHG=ON). If the charge switch is to be closed, the BMS further determines whether a difference between a total internal voltage and a total external voltage is less than Vd1. If the difference is less than Vd1, the BMS closes the charge switch to make CHG=ON to end the operation; or if the difference is not less than Vd1, closing the CHG fails, and the BMS ends the operation. Herein, Vd1 is 0.7 V, but not limited thereto. If the CHG is not to be closed, the BMS further determines whether to open the CHG. If the CHG is to be opened, the BMS makes CHG=OFF, and ends the operation. Otherwise, the BMS ends the discharge operation.

Back to FIG. 2, a voltage between two ends B+ and B- of the battery cells in the battery pack is the total internal voltage of the PACK, where B+ represents the positive electrode of the battery cells, and B- represents the negative electrode of the battery cells. The total internal voltage of the PACK is a voltage not through the BMS. A voltage between two ends P+ and P- at the front side of the vehicle load is the total external voltage of the PACK, where P+ is the positive electrode of the power bus, and P- is the negative electrode of the power bus.

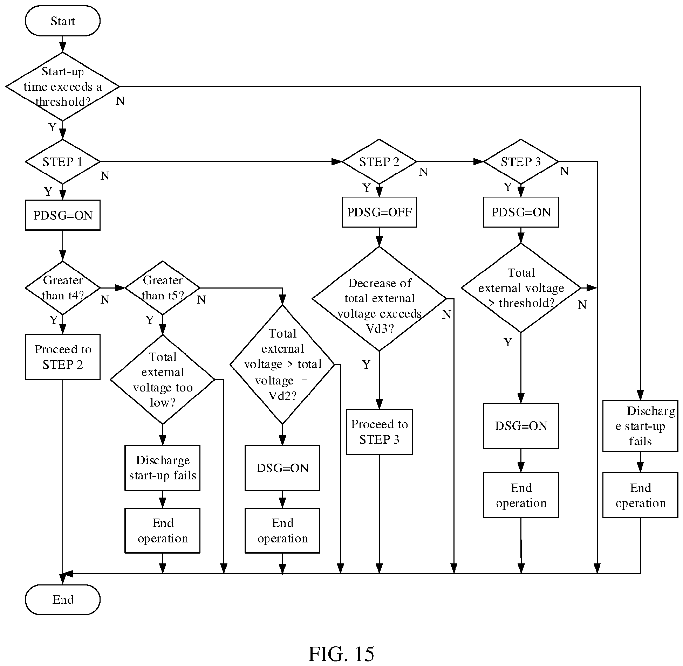

FIG. 15 is a flowchart of a method for performing discharge start-up by a BMS (for example, BMS 1) according to some embodiments of this application. In FIG. 15, after performing a discharge start-up operation, the BMS determines whether the start-up time exceeds a threshold. If the threshold is exceeded, the BMS determines that the discharge start-up fails, and ends the operation; or if the threshold is not exceeded, the BMS further determines whether to perform step 1 (that is STEP 1). If determining to perform STEP 1, the BMS further determines whether the start-up time is greater than a preset time t4 after closing the pre-discharge switch or PDSG. If the start-up time is greater than t4, the BMS proceeds to step 2 (that is STEP 2); or if the start-up time is not greater than t4, the BMS further determines whether the start-up time is greater than a preset time t5. Herein, t4 is 1.5s, and t5 is Is, but they are not limited thereto. If the start-up time is greater than t5, the BMS further determines whether the total external voltage is too low. If the total external voltage is too low, the discharge start-up fails, and the operation is ended; or if the start-up time is not greater than t5, the BMS determines whether the total external voltage is greater than a difference between a total voltage and Vd2. If the total external voltage is greater than the difference, the BMS ends the operation after closing the discharge switch or DSG; or if the total external voltage is not greater than the difference, the BMS ends the operation. Herein, Vd2 is 1.2 V, but not limited thereto. If determining not to perform STEP 1, the BMS further determines whether to perform STEP 2. If determining to perform STEP 2, the BMS opens the pre-discharge switch, or makes PSDG=OFF, and further determines whether a decrease of the total external voltage exceeds Vd3. If yes, the BMS proceeds to STEP 3; or if no, ends the operation. Herein, Vd3 is 4 V, but not limited thereto. If determining not to perform STEP 2, the BMS further determines whether to perform STEP 3. If STEP 3 is to be performed, the BMS further determines whether the total external voltage is greater than a preset threshold after closing the pre-discharge switch to make PDSG=ON. If yes, the BMS ends the operation after closing the discharge switch to make DSG=ON; or if no, ends the operation.

Specifically, in STEP 1, there are two situations after the PDSG is closed: First, the total external voltage is low, which means that the vehicle load exceeds a defined value, and the discharge start-up fails; second, the total external voltage is close to the total internal voltage, the DSG is closed, and the discharge start-up succeeds; third, after expiry of a given period of time, STEP 2 continues to be performed. In STEP 2, after the PDSG is opened, if a decrease of the total external voltage exceeds a given value, the BMS determines that no battery pack with unexpected communication is present outside. In STEP 3, on the basis of the determination in STEP 2 that no battery pack with unexpected communication is present outside, if the pre-discharge voltage is above a threshold, the DSG is closed, and the discharge start-up succeeds.

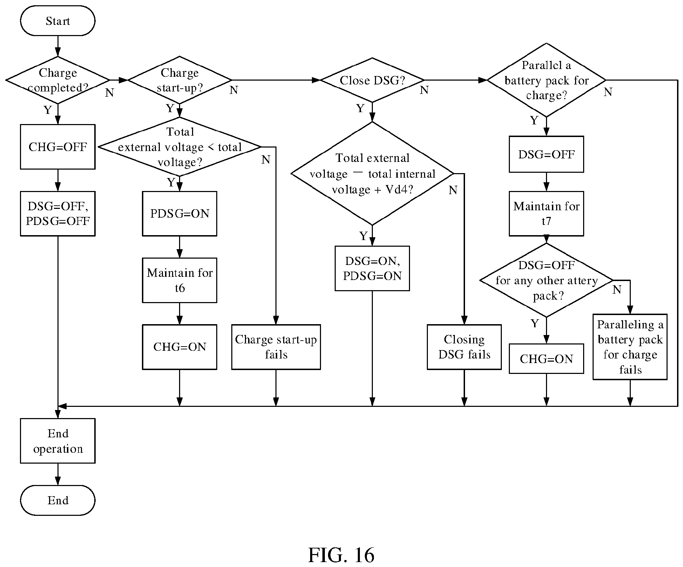

FIG. 16 is a flowchart of a method for performing a charge operation by a BMS according to some embodiments of this application. In FIG. 16, the BMS determines whether charging is completed after performing charge processing. If yes, the BMS closes the charge switch to make CHG=ON, and closes the discharge switch and the pre-discharge switch to make DSG=ON and PDSG=ON to end the charge operation; or if no, the BMS determines whether to perform a charge start-up operation. If a charge start-up operation is to be performed, the BMS further determines whether the total external voltage is less than the total internal voltage. If yes, the BMS makes PDSG=ON, and after maintaining this for a time of t6, makes CHG=ON; or if no, the charge start-up fails. Herein, t6 is Is, but not limited thereto. If the charge start-up operation is not to be performed, the BMS further determines whether to close the DSG. If the DSG is to be closed, the BMS further determines whether the total external voltage equals a sum of the total internal voltage and VD4. If yes, the BMS makes DSG=ON and PDSG=ON; or if no, closing the DSG fails. If the DSG is not to be closed, the BMS further determines whether to perform an operation to parallel a battery pack for charge. If an operation to parallel a battery pack for charge is to be performed, the BMS makes DSG=OFF and maintains this for a time of t7, and further determines whether the DSG of any other battery pack is opened; and if yes, the BMS makes CHG=ON and then ends the operation; or if no, paralleling a battery pack for charge fails. If no operation to parallel a battery pack for charge is to be performed, the BMS ends the operation. Herein, t7 is Is, but not limited thereto.

Based on the embodiments of the control method for a single battery pack (for example, BMS 1) in a battery pack system shown in FIGs. 3 to 16, any one of the battery packs in PACK 1 to PACK N may switch between the charge state, discharge state, and standby state (that is, the disconnected state) independent of other battery packs based on its own state and states of the other battery packs, thereby implementing dynamic management on parallel connection of battery packs without any additional host control module set up. This can meet the demands for large power output and capacity expansion of the vehicle load in real time, with strong versatility and low costs.

Some embodiments of this application further provide a BMS, applied to the foregoing battery packs, to perform the foregoing method for parallel connection management. The BMS has the same functions as any one of BMS 1, BMS 2, ..., and BMS N.

Some embodiments of this application further provide a battery pack, including the foregoing BMS and battery cells, and having the same functions as any one of PACK 1, PACK 2, ..., and PACK N.

References to "some embodiments", "some of the embodiments", "an embodiment", "another example", "examples", "specific examples" or "some examples" in the specification mean the inclusion of specific features, structures, or characteristics described in the embodiment or example in at least one embodiment or example of this application. Therefore, descriptions in various places throughout the specification, such as "in some embodiments", "in the embodiments", "in an embodiment", "in another example", "in an example", "in a specific example" or "examples", do not necessarily refer to the same embodiment or example in this application.

Although illustrative embodiments have been demonstrated and described, those skilled in the art should understand that the above embodiments are not to be construed as limiting this application, and that the embodiments may be changed, replaced, and modified without departing from the spirit, principle, and scope of this application.

## Claims

1. A method for dynamically managing parallel connection of a plurality of battery packs, applied to a first battery pack, **characterized in that** the first battery pack comprises battery cells and a BMS, and the method comprises:
monitoring, by the BMS, states of the first battery pack and other battery packs, the states of the first battery pack and the other battery packs comprising a disconnected state and a connected state; and
when the BMS determines that a difference between a power level of the first battery pack and a power level of another power pack in the connected state is in a preset threshold range,
controlling, by the BMS based on the determination, the first battery pack to switch from the disconnected state to the connected state, the first battery pack being connected in parallel with the another battery pack;
wherein the connected state comprises a charge state and a discharge state, and the first battery pack is charged in the charge state and discharged in the discharge state.

2. The method according to claim 1, wherein when detecting a discharge signal and detecting that the other battery packs are in the disconnected state and that the first battery pack has a highest power level among the plurality of battery packs, the BMS controls the first battery pack to switch from the disconnected state to the discharge state.

3. The method according to claim 1, wherein when a charge signal is detected and it is detected that the other battery packs are in the disconnected state and that the first battery pack has a lowest power level among the plurality of battery packs, the first battery pack is controlled to switch from the disconnected state to the charge state.

4. The method according to claim 1, wherein a step of the first battery pack switching from the discharge state to the charge state comprises: switching from the discharge state to the disconnected state, and then from the disconnected state to the charge state.

5. The method according to claim 1, wherein a step of the first battery pack switching from the charge state to the discharge state comprises: switching from the charge state to the disconnected state, and then from the disconnected state to the discharge state.

6. The method according to claim 1, wherein when it is detected that the first battery pack is in the connected state and fails, the first battery pack is controlled to switch from the connected state to the disconnected state.

7. A management system comprising a plurality of battery packs, the plurality of battery packs comprising a first battery pack and other battery packs, wherein the first battery pack comprises battery cells and a BMS, **characterized in that** the management system comprises:
a communications cable, wherein the first battery pack and the other battery packs are connected to the communications cable;
the BMS comprising a charge control module, a discharge control module, and a pre-discharge control module; and
a main control module, configured to:
monitor the first battery pack and report a state of the first battery pack to the communications cable, and obtain states of the other battery packs from the communications cable, the states of the first battery pack and the other battery packs comprising a disconnected state and a connected state, and
when the BMS determines that a difference between a power level of the first battery pack and a power level of another power pack in the connected state is in a preset threshold range, the BMS controls, based on the determination, the charge control module, the discharge control module, and the pre-discharge control module to parallel the first battery pack to the another battery pack to switch the first battery pack from the disconnected state to the connected state;
wherein the connected state comprises a charge state and a discharge state, and the first battery pack and the other battery packs are charged in the charge state and discharged in the discharge state.

8. The battery pack management system according to claim 7, wherein the charge control module and the discharge control module are connected in series.

9. The battery pack management system according to claim 7, wherein the pre-discharge control module is connected in parallel with the charge control module and the discharge control module which are connected in series.

10. The battery pack management system according to claim 8, wherein the first battery pack switches from the disconnected state to the connected state when both the charge control module and the discharge control module are closed.

11. The battery pack management system according to claim 10, wherein the main control module is further configured to: when detecting a charge signal and detecting that the other battery packs are in the disconnected state and that the first battery pack has a lowest power level among the plurality of battery packs, control the charge control module and the discharge control module to close to switch the first battery pack from the disconnected state to the charge state.

12. The battery pack management system according to claim 10, wherein the main control module is further configured to: when detecting a discharge signal and detecting that the other battery packs are in the disconnected state and that the first battery pack has a highest power level among the plurality of battery packs, control the charge control module and the discharge control module to close to switch the first battery pack from the disconnected state to the discharge state.

13. The battery pack management system according to claim 10, wherein the main control module is further configured to: when controlling the discharge control module, the charge control module, and the pre-discharge control module to switch the first battery pack between the charge state and the discharge state, control all of the discharge control module, the charge control module, and the pre-discharge control module to disconnect and then close.

14. The battery pack management system according to claim 7, wherein the main control module is further configured to: when detecting that a change in load current exceeds a preset value, control the discharge control module to close.

15. The battery pack management system according to claim 7, wherein the discharge control switch, the charge control module and the pre-discharge control module each comprise a switch and a freewheel diode.

16. A battery pack, **characterized by** comprising the battery pack management system according to any one of claims 7 to 15.

17. A vehicle, **characterized by** comprising the battery pack according to claim 16.

18. The vehicle according to claim 17, wherein the vehicle further comprises a plurality of battery compartments, the plurality of battery packs being arranged in the battery compartments.

19. A method for dynamically managing parallel connection of a plurality of battery packs, applied to the plurality of battery packs, **characterized in that** the method comprises:
monitoring states of a first battery pack and other battery packs, the states of the first battery pack and the other battery packs comprising a disconnected state and a connected state;
when the plurality of battery packs are all in the disconnected state, and a difference between a power level of the first battery pack and a power level of another power pack is in a preset threshold range, controlling the first battery pack to switch from the disconnected state to the connected state; and
controlling the first battery pack to switch between the connected state and the disconnected state independent of the other battery packs,
wherein the connected state comprises a charge state and a discharge state, and the first battery pack and the other battery packs are charged in the charge state and discharged in the discharge state.
